Europäisches Patentamt

European Patent Office

Office européen des brevets

(11) Numéro de publication: **0 345 181**
**A1**

(12) **DEMANDE DE BREVET EUROPEEN**

(21) Numéro de dépôt: **89430012.8**

(22) Date de dépôt: **19.05.89**

(51) Int. Cl.⁴: **G 01 R 27/02**
**G 01 R 27/26**

(30) Priorité: **30.05.88 FR 8807319**

(43) Date de publication de la demande:
**06.12.89 Bulletin 89/49**

(84) Etats contractants désignés:
**AT BE CH DE ES FR GB GR IT LI LU NL SE**

(71) Demandeur: **Garcia, Manuel**
**2, Avenue Pacifique Rovali**
**F-13830 Roquefort la Bedoule (FR)**

**Beyma, Alain**
**Résidence les Lavandes 13, Boulevard de Gabès**
**F-13008 Marseille (FR)**

(72) Inventeur: **Garcia, Manuel**
**2, Avenue Pacifique Rovali**
**F-13830 Roquefort la Bedoule (FR)**

**Beyma, Alain**
**Résidence les Lavandes 13, Boulevard de Gabès**
**F-13008 Marseille (FR)**

(74) Mandataire: **Moretti, René et al**
**c/o Cabinet BEAU DE LOMENIE "Prado-Mermoz" 232,**
**Avenue du Prado**
**F-13008 Marseille (FR)**

(54) Procédé et dispositif de détection et de reconnaissance d'impact par mesure de variation d'impédance.

(57) La présente invention a pour objet des procédés et des dispositifs de détection et de reconnaissance d'impact par mesure de variation d'impédance.

Ce dispositif est relié à un système électronique (10) extérieur qui mesure en permanence l'impédance du capteur (6). Après une période d'apprentissage, le système électronique enregistre l'impédance du dispositif au repos, puis après cette période, dès lors qu'une action quelconque (9) est effectuée sur le dispositif, l'impédance du dispositif varie avec une certaine vitesse, le système peut alors détecter la dérivée de la vitesse de variation d'impédance ou suivant l'application la variation pure d'impédance et transmettre un signal à l'utilisateur (16).

Le capteur (6) est constitué d'une enveloppe (3) souple, protégeant deux couches (1 et 2) souples ou non de matériaux conducteurs d'électricité en contact ou non l'une de l'autre, sur lesquelles viennent les contacts électriques (7), reliés eux-mêmes par l'intermédiaire de fils conducteurs électriques (4) au système électronique extérieur (10).

Fig 1

EP 0 345 181 A1

# Description

**Procédé et dispositif de détection et de reconnaissance d'impact par mesure de variation d'impédance.**

La présente invention a pour objet des procédés et des dispositifs de détection et de reconnaissance d'impact par mesure de variation d'impédance.

Le secteur technique de l'invention est la fabrication de capteurs associés à un appareil de mesure et de calcul, permettant la détection, et surtout la reconnaissance d'impacts sur toute surface équipée d'un capteur.

Une des applications principales de l'invention concerne tout les domaines de la surveillance des locaux pour déclencher tout type d'alerte, dès la détection d'une intrusion prédéterminée dans ces locaux, et ceux de la mécanique des fluides, et de la réalisation de peaux artificielles.

Une autre application est son utilisation dans le domaine sportif, chaque fois que l'on veut détecter par exemple la frappe d'une balle sur ou en dehors d'une ligne déterminée comme au tennis, sans être perturbé par d'autre type d'impact, comme ceux provoqués par les pieds des joueurs.

On connaît en effet divers procédés et dispositifs de détection utilisant diverses techniques : certains sont actifs; ils émettent des ondes, soit lumineuses, soit acoustiques, soit électromagnétiques et, par réflexion de celles-ci, ils détectent toute masse ou objet identifié ou non, qui se déplace ou se place dans l'espace qu'ils contrôlent.

D'autres dispositifs sont plutôt passifs; ils n'émettent aucune onde ni signal en l'absence de perturbation et ne se déclenchent qu'en cas de changement dans l'état du paramètre qu'ils contrôlent (tel que la température, la pression, le contact, la luminosité, le bruit etc...).

Chacun des procédés et dispositifs correspondant répond à une utilisation donnée, compte tenu des critères de détection souhaitée, et chacun a une fiabilité et une qualité propre. En particulier, quand on souhaite, comme pour la présente invention, détecter des impacts, on utilise essentiellement, soit de simples systèmes à contacts en tout ou rien qui ne déclenchent donc qu'à un seuil déterminé de déplacement dudit contact, soit des capteurs de mesure, qui permettent d'essayer de connaître au mieux la variation d'un paramètre physique tel que la pression, afin d'avoir une mesure quantitative de l'impact à partir de laquelle on peut déclencher diverses actions.

Dans ce domaine, on peut citer la demande de brevet de la Société "THE BENDIX CORPORATION", déposée le 15 Février 1978 aux ETATS-UNIS sous le NO. 878,056 et décrivant un "ensemble comportant un capteur capacitif et un circuit de démodulation", dont les revendications portent essentiellement sur ce circuit qui doit compenser les variations du signal de sortie produit par les erreurs de système : en effet, il est connu que toute mesure de capacité d'un circuit est fonction en particulier de la température et de l'hygrométrie du milieu. Il est donc nécessaire dans ce type de capteur et d'appareil, de corriger alors celle-ci, pour comparer des mesures de pression dans les même conditions.

Diverses autres demandes de brevets ont été déposées pour d'autres types de capteurs capacitifs, tel que la demande de la Société S.I.E. GmbH en ALLEMAGNE FEDERALE, sous le NO. G 87 06 280.1 du 1er Mai 1987, décrivant un capteur comportant trois électrodes flexibles et un circuit électronique délivrant un signal fonction de la déformation de ces électrodes due par exemple à la variation de la pression sur le capteur.

Pour obtenir des informations non seulement sur un point, mais sur une surface, divers capteurs ont été développés pour détecter des déformations de celles-ci toujours en utilisant des mesures électriques. La demande de brevet NO. 75/34.225 déposée le 05 Novembre 1975 par l'AGENCE NATIONALE DE VALORISATION POUR LA RECHERCHE -A.N.V.A.R., décrit un capteur tactile, dans le but de créer une "peau artificielle", comportant une multitude d'électrodes de mesure et d'éléments conducteurs, imbriqués les uns dans les autres et noyés dans un matériau dont la conductivité électrique dépend de sa compression.

On pourrait citer d'autres demandes de brevets concernant divers autres dispositifs, dont l'objectif est de mesurer la pression subie par un support, sous l'effet par exemple d'une charge et à base de circuit capacitif.

La présente invention rentre dans cette catégorie de dispositifs et, plus spécialement à ceux destinés à des détections, sur des surfaces, d'impacts et à la reconnaissance de ces impacts pour déclencher des actions sélectives.

La plupart des systèmes cités précédemment sont effet basés :
- soit sur des mesures actives par émission d'ondes dont la réflexion est essentiellement monoqualitative et permet une détection en fait par tout ou rien, ou si l'on veut en plus soit une mesure multiqualitative, soit une mesure quantitative par ces procédés, cela nécessite des appareillages d'analyse de forme et de calcul très complexes et très coûteux;
- soit sur des mesures passives par calcul de la grandeur que l'on peut alors quantifier pour en interpréter l'origine et en déduire une analyse qualitative pour sélectionner les actions souhaitées, mais dont la fiabilité est douteuse et le réglage doit être permanent.

Aucun de ces systèmes ne permet donc une utilisation à la fois pour la détection d'impacts, quelles que soient la situation et les conditions d'environnement, et surtout pour la reconnaissance de ces impacts sans un appareillage complexe ou un réglage permanent.

Un des problèmes posés est en effet de pouvoir détecter et sélectionner en particulier sur une surface donnée, au moins un type d'impact que l'on s'est préalablement défini et seulement celui-ci, et cela dans toute circonstance et quel que soit l'état de ladite surface au moment de l'impact.

Une solution au problème posée est un procédé de détection et de reconnaissance d'impact reçu par une surface, comportant les opérations suivantes :
- on dispose au moins deux couches de matériaux, conducteurs d'électricité en contact l'une de l'autre, pour constituer un capteur, dont on recouvre ladite surface ;
- on relie chacune des couches externes à une borne d'un système électronique comportant au moins un générateur de courant, constant parcourant alors lesdites couches, un microprocesseur associé au moins à une mémoire et permettant en particulier la mesure de la différence de potentiel aux bornes dudit capteur, et diverses interfaces d'entrées-sorties ;
- on calcule la vitesse de variation de l'impédance de ce capteur qui change quand il est soumis à un phénomène physique différent de celui de sa situation initiale, laquelle vitesse de variation d'impédance est directement proportionnelle à la dérivée de la différence de potentiel mesurée;
- dans une première phase d'apprentissage, on enregistre dans ladite mémoire du système électronique, la valeur de l'impédance du capteur dit alors au repos et correspondant à une situation initiale donnée, et à chaque variation de cette impédance dans la phase d'utilisation, ledit microprocesseur ayant été préalablement programmé pour cela, adresse un signal donné à travers une interface de sortie, dès que la vitesse de ladite variation dépasse un seuil déterminé.

Une autre solution au problème posé est un dispositif de détection et de reconnaissance d'impact reçu par une surface de type comportant un capteur de pression par mesure de l'impédance dudit capteur associé à un système électronique permettant ladite mesure, dans lequel ledit capteur est constitué au moins de deux couches de matériaux conducteurs d'électricité, en contact et disposées par exemple parallèles l'une sur l'autre, recouvrant ladite surface, et dont les couches externes sont reliées chacune depuis au moins un point quelconque de leurs surfaces à une borne dudit système électronique. Ce système électronique comporte au moins un générateur de courant constant parcourant alors lesdites couches, un microprocesseur associé à au moins une mémoire et permettant en particulier la mesure de la différence de potentiel au bord dudit capteur, le calcul de la dérivée de cette différence de potentiel, la comparaison du résultat obtenu à des valeurs de dérivées stockées dans ladite mémoire et associés à un type d'impact déterminé préalablement, et l'émission de signal à travers au moins une interface de sortie, quand ladite comparaison correspond à un choix de détection et de reconnaissance voulu.

Dans un mode de réalisation préférentiel un procédé de détection et de reconnaissance d'impact suivant la présente invention, comporte les opérations suivantes :
- lors de ladite première phase d'apprentissage, on associe et on stocke dans ladite mémoire du système chaque dite vitesse de variation et la nature du phénomène alors connu qui a provoqué cette variation et qui lui est spécifique pour ladite surface;
- on établit une classification et une sélection parmi tous les phénomènes qui peuvent provoquer une variation de l'impédance, et on programme ledit microprocesseur pour que dans la phase d'utilisation, il adresse un signal donné vers une interface de sortie pour seulement certaines vitesses de variation de cet impédance.

Le résultat est de nouveaux procédés et dispositifs de détection d'impacts par mesures de vitesse de variation d'impédance, dont les caractéristiques permettent de satisfaire diverses applications, quelles que soient les conditions d'environnement de celle-ci.

En effet, la présente invention a pour principal avantage de permettre une mesure qualitative du phénomène et non quantitative. En effet, actuellement, il n'existe pas de capteur pouvant réagir aux impacts et de les discriminer.

Le dispositif suivant l'invention décrit ci-après n'est pas un capteur de mesure au sens propre du terme.

Ainsi, la présente invention peut avoir de multiples applications en tant qu'interrupteur, contact et détection dans les domaines tels que la surveillance, la sécurité, la gestion de stock, le sport, la mécanique des fluides, la robotique (peau artificielle), l'acoustique etc....

Compte tenu des faibles courants considérés pour son fonctionnement, les capteurs suivant l'invention peuvent fonctionner dans n'importe quelle atmosphère et même dans l'eau, car ils ne présentent aucun risque d'électrocution.

De plus, la forme du capteur importe peu pour le fonctionnement du procédé : on peut même envisager que l'adaptation de forme pourra être faite par l'utilisateur final qui adapte ledit capteur sur la surface qu'il détermine, tant en dimension qu'en mise en forme sur celle-ci, puisque dans la présente invention, l'état initial qui détermine la valeur de l'impédance du capteur dit au repos, n'intervient pas dans l'analyse de la variation de celle-ci.

On peut installer le dispositif sur tout support et surface.

On a pu constater, mesurer et enregistrer, qu'une fois la mise en place sur une surface donnée, la dérivée de l'impédance du capteur est toujours la même pour un impact donné, quelles que soient la valeur initiale de cette impédance avant l'impact, et les autres conditions d'environnement qui peuvent ainsi changer dans le temps comme en particulier, la température, l'hygrométrie ou même avec toute charge posée sur la surface et donnant une déformation quasi permanente audit capteur.

L'information recueillie est alors l'image non quantifiée du phénomène, mais dont les caractéristiques qualitatives déterminées par une ou plusieurs valeurs de dérivées, associée ou non à une durée et à une ou des accélérations, permettent de classer ledit phénomène d'une manière certaine et donc de le reconnaître, de le sélectionner au milieu d'autres et de déclencher toute action souhaitée suivant l'usage retenu.

Dans le dispositif suivant, nous décrirons essentiellement un exemple de procédé et de dispositif suivant l'invention, mais d'autres réalisations peuvent être envisagées et les figures, dessins et descriptifs ci-après n'ont aucun caractère limitatif.

La figure 1 est une vue d'un exemple de dispositif suivant l'invention, comportant un capteur en coupe et un schéma d'un système électronique associé.

La figure 2 est un schéma plus détaillé de principe dudit système électronique.

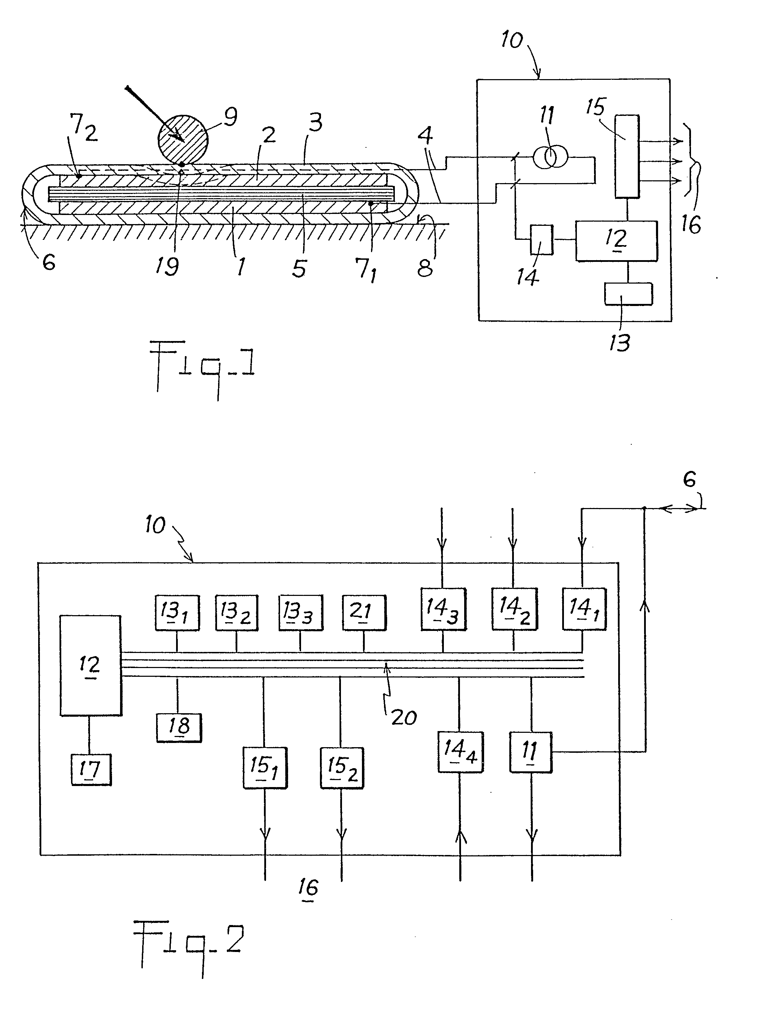

La figure 1 représente une vue en coupe d'un capteur 6 suivant l'invention, posé sur une surface 8 quelconque et relié à un système électronique 10, dont un exemple de schéma plus détaillé est décrit dans la figure 2.

Le capteur 6 est constitué essentiellement d'au moins deux couches 1 et 2 de matériaux conducteurs de tout type, compressibles ou non, souples ou non, et en contact les unes des autres. Les couches de matériaux sont disposées de préférence, parallèles l'une sur l'autre et recouvrent la surface 8 sur laquelle le capteur doit détecter les impacts et les reconnaître. Ainsi, de préférence, lesdites couches sont souples pour épouser la forme de ladite surface et leur dimension extérieure peut être quelconque.

Dans un mode de réalisation préférentiel, ces couches sont séparées par une couche 5 de matériau. Quand les couches 1 et 2 sont constituées de matériaux non compressibles, celui de la couche intermédiaire 5 peut être :
- soit conducteur, souple, compressible, déformable et élastique permettant alors de différencier plus facilement des objets 9, qui viennent frapper la face supérieure du capteur 6, en un point d'impact 19, et comprimer ainsi plus ou moins en valeur et en vitesse cette couche intermédiaire 5, créant ainsi une variation d'impédance plus facile à détecter et à mesurer;
- soit isolant, souple et ajouré et pouvant permettre alors une discrimination géographique de l'endroit où se trouve le point d'impact 19 sur la surface du capteur.

Quand les couches 1 et 2 sont constituées de matériau compressible, déformable et élastique (mousse conductrice par exemple), ce matériau de la couche intermédiaire 5 peut être comme ci-dessus, et même non compressible, car la compression affecte alors de toute façon les couches extérieures.

Dans un autre mode de réalisation, on peut constituer un capteur en remplissant un fourreau de toute forme de plusieurs morceaux distincts de matériau conducteur, type morceau de mousse, constituant autant de couches externes et intermédiaires, dont on relie les extrémités au système électronique 10.

De plus, les couches conductrices 1 et 2 sont reliées chacune depuis au moins un point quelconque $7_1$ et $7_2$ respectivement de leur surface, par des contacts de tout type connu tel que rivets, bornes à visser, soudure etc..., à des conducteurs 4, connectés eux-mêmes à un système électronique 10.

Dans un mode de réalisation préférentiel, cesdits points $7_1$ et $7_2$ sont éloignés le plus possible l'un par rapport à l'autre, car plus ils sont éloignés les uns des autres, plus la sensibilité du dispositif est grande.

Dans une variante de l'invention, ces couches conductrices 1 et 2 constituent elles-mêmes l'enveloppe du capteur 6, et dans une autre variante, ces couches sont enfermées et recouvertes dans une enveloppe protectrice souple 3, dont les extrémités et les bords sont refermés par n'importe quel moyen, lesdites couches pouvant être solidaires ou non de cette enveloppe.

L'épaisseur de cesdites couches et enveloppes peut être quelconque, mais de préférence assez mince, pour constituer un capteur assez plat et donc discret.

Ledit système électronique 10 comporte au moins un générateur 11 de courant constant, afin de ne pas être influencé par la longueur des conducteurs 4 et qui, par exemple produit un courant très faible de l'ordre de 20 mA et même moins.

En parallèle et suivant par exemple le schéma de la figure 2, ledit système 10 comprend aussi un convertisseur analogique digital 14 qui transmet à un microprocesseur 12 la valeur de la différence de potentiel U mesurée aux bornes du capteur sur les fils d'alimentation 4 suivant la formule $U = ZI$, dans laquelle l'intensité I est donc constante et Z représente l'impédance du circuit électrique constitué par le capteur 10 : à un instant donné considéré alors au repos, l'impédance et l'intensité étant constantes, la dérivée $\delta U$ de la tension est nulle et quand un objet 9 frappe le capteur 10, la déformation des couches conductrices 1 et 2, et éventuellement de la couche intermédiaire 5, provoque une variation de l'impédance du circuit, dont la dérivée est alors directement proportionnelle à celle de la tension mesurée :
$$\delta U = f(z) \, dt \text{ car } \delta I = 0$$
où $f(z)$ = dérivée de l'impédance.

On a pu expérimenter et vérifier que pour un capteur suivant l'invention, adapté à une surface donnée, et pour un impact déterminé, cette dérivée était constante, quelle que soit la valeur $Z_0$ de l'impédance initiale du capteur avant l'impact et permet donc de reconnaître divers types d'impacts et de sélectionner ceux pour lesquels on veut pouvoir agir sur des éléments externes 16, à travers une interface 15, en ignorant ceux qui n'intéressent pas l'utilisateur. Ainsi, dans une utilisation sur un terrain de tennis, dans lequel les bandes qui délimitent celui-ci seraient muni d'un dispositif suivant l'invention, ce dispositif ne pourrait agir seulement lorsqu'une balle touche lesdites bandes et ne pas réagir quand c'est le joueur qui marche dessus.

Pour cela, il est nécessaire alors d'effectuer pour chaque utilisation et surface donnée une phase d'apprentissage, durant laquelle on enregistre dans une mémoire 13 associée au microprocesseur 12, les vitesses ou les dérivées de variation de ladite impédance correspondant aux impacts que l'on veut sélectionner ou au contraire éliminer.

Le rôle du microprocesseur est de calculer à tout moment cette dérivée, et ladite mémoire 13, ou une autre, contient également tout le programme d'application qui, dans la phase d'utilisation, exploite le résultat du calcul et le compare à un ou plusieurs seuils figés ou paramétrés pendant la phase d'apprentissage, afin de déclencher ou non l'action souhaitée.

Lors de la première mise sous tension, le programme initialise le système et il est possible également après toute détection de variation de l'impédance du capteur, quand celle-ci prend ensuite toujours les mêmes valeurs de dérivées pendant une durée minimum déterminée, de programmer le microprocesseur 12 pour qu'il prenne comme nouvelle valeur de l'impédance du capteur au repos, celle correspondant à sa valeur de dérivée nulle, et qu'il ne détecte ensuite que les variations d'impédance créées par un nouvel impact qui produit une dérivée différente desdites valeurs ci-dessus.

De plus ladite valeur de l'impédance de référence du capteur considéré au repos à un instant donné peut être réactulisé à des intervalles de temps donné tel que quelques microsecondes, correspondant à un cycle de programme dudit microprocesseur 12 et adapté à une application donnée.

De toute façon, comme nous l'avons déjà expliqué, le procédé suivant l'invention utilise le calcul de la dérivée de la valeur d'impédance et non sa valeur absolue : ainsi toute variation lente telle que due à la température ou à l'hygrométrie, induit une dérivée très faible, qui sera en-dessous de tout seuil correspondant à un impact, et ne déclenchera pas, si on le désire, d'action.

Si l'on souhaite une plus grand discrimination dans l'analyse des impacts, on peut enregistrer, avec chaque valeur de la vitesse de variation de l'impédance, la durée pendant laquelle cette vitesse peut rester constante, ainsi que les dérivées de la vitesse entre l'état dit au repos du capteur et son retour à cet état.

La figure 2 est un schéma plus détaillé de principe de ce que peut être un système électronique 10, tel que présenté dans la figure 1 et très complet, pour toute utilisation suivant l'invention.

Il comprend divers composants électroniques connus et seuls la combinaison et le procédé d'utilisation de ceux-ci avec un programme spécifique tel que décrit précédemment, fait l'objet de la présente invention.

On retrouve donc le microprocesseur 12 qui peut être par exemple de type CPU, fonctionnant à 4MHz et 8 bits, et qui peut être contrôlé par un superviseur 17, associé à une horloge. Ce microprocesseur est relié par un bus central 20, permettant de rajouter ensuite si nécessaire diverses autres cartes d'extension, à des cartes spécifiques, correspondant chacune à une fonction du système : on trouve tout d'abord, des cartes mémoires 13, dont l'une au moins peut recevoir le programme suivant le procédé de l'invention et une autre au moins les données de comparaison des dérivées des impédances associées aux impacts correspondants et de référence.

Le bus 20 est aussi relié à une carte de décodage 21, éventuellement nécessaire pour certaines informations d'entrée et de sortie, et à un générateur de bauds 18.

Le générateur 11 de courant constant peut être un convertisseur digital analogique, contrôlé par le microprocesseur et assurant au capteur 6, sur une de ses voies de sortie, une alimentation de courant constant égal par exemple à 20 mA.

En retour et en parallèle, un convertisseur analogique digital $14_1$ recueille la variation de tension au bord du capteur 6 et la transmet au microprocesseur 12, pour calcul de la dérivée et comparaison puis action éventuelle à travers diverses interfaces de sortie 15, vers des actionneurs externes 16. Ces interfaces de sortie peuvent générer des courants forts pour agir sur des relais et comprendre elles-mêmes une capacité mémoire tampon.

D'autres cartes d'entrée 14 peuvent être gérées par le même système et recevoir des informations d'autres capteurs externes, en particulier, une desdites cartes $14_4$ peut être connectée à un simple capteur agissant en tout ou rien à la manière d'un compteur, lequel capteur peut être réalisé suivant le descriptif de l'invention ci-dessus, dont on peut utiliser alors directement si cela suffit l'impédance et non plus sa vitesse ou dérivée.

Cette configuration de système électronique 10 peut ainsi convenir et être associée à tout type de détection et d'action, dont en particulier celles suivant le procédé de l'invention, lequel procédé peut être exploité avec un seul système électronique 10, connecté à plusieurs capteurs et dispositifs suivant le descriptif précédent.

Il est à noter que les procédés et dispositifs suivant l'invention décrite permettent la détection et la reconnaissance non seulement d'impacts, mais également de retraits, phénomènes symétriques et mesurables de la même façon comme par exemple quand on retire un objet d'une surface.

**Revendications**

1. Procédé de détection et de reconnaissance d'impact reçu par une surface, caractérisé en ce que :
- on dispose au moins deux couches de matériaux (1 et 2), conductrices d'électricité et en contact l'une de l'autre, pour constituer un capteur (6), dont on recouvre ladite surface (8) ;
- on relie chacune des couches externes à une borne d'un système électronique (10) comportant au moins un générateur (11) de courant constant parcourant alors lesdites couches, un microprocesseur (12) associé au moins à une mémoire (13) et permettant en particulier la mesure de la différence de potentiel aux bornes dudit capteur, et diverses interfaces d'entrées-sorties (15) ;
- on calcule la vitesse de variation de l'impédance de ce capteur qui change quand il est soumis à un phénomène physique différent de celui de sa situation initiale, laquelle vitesse de variation d'impédance est directement proportionnelle à la dérivée de la différence de potentiel mesurée ;
- dans une première phase d'apprentissage. on enregistre dans ladite mémoire du système électronique (10), la valeur de l'impédance du capteur dit alors au repos et correspondant à une situation initiale donnée, et à chaque variation de cette impédance dans la phase d'utilisation, ledit microprocesseur ayant été programmé préalablement pour cela, adresse un signal donné à travers une interface de sortie (15), dès que la vitesse de ladite variation dépasse un seuil déterminé.

2. Procédé de détection et de reconnaissance d'impact suivant la revendication 1, caractérisé en ce que :
- lors de ladite première phase d'apprentissage, on associe et on stocke dans ladite mémoire (13) du système chaque dite vitesse de variation et la nature du phénomène alors connu qui a provoqué cette variation et qui lui est spécifique pour ladite surface;
- on établit une classification et une sélection parmi tous les phénomènes qui peuvent provoquer une variation de l'impédance. et on programme ledit microprocesseur (12) pour que dans la phase d'utilisation, il adresse un signal donné vers une interface de sortie (15) pour seulement certaines vitesses de variation de cet impédance.

3. Procédé suivant l'une quelconque des revendications 1 et 2, caractérisé en ce que l'on enregistre, avec chaque valeur de la vitesse de variation de l'impédance, la durée pendant laquelle cette vitesse peut rester constante, ainsi que les dérivées de la vitesse entre l'état dit au repos du capteur et son retour à cet état.

4. Procédé suivant l'une quelconque des revendications 1 à 3, caractérisé en ce que, après toute détection de variation de l'impédance du capteur, quand celle-ci prend ensuite toujours les mêmes valeurs de dérivées pendant une durée minimum déterminée, on programme le microprocesseur (12) pour qu'il prenne comme nouvelle valeur de l'impédance du capteur au repos, celle correspondant à sa valeur de dérivée nulle, et qu'il ne détecte ensuite que les variations d'impédance créées par un nouvel impact qui produit une dérivée différente desdites valeurs ci-dessus.

5. Procédé suivant l'une quelconque des revendications 1 à 4, caractérisé en ce qu'on réactulise ladite valeur de l'impédance de référence du capteur considéré au repos à un instant donné à des intervalles de temps tel que quelques microsecondes correspondant à un cycle de programme dudit microprocesseur (12) et adapté à une application donnée.

6. Dispositif de détection et de reconnaissance d'impact (9) reçu par une surface (8) de type comportant un capteur (6) de pression par mesure de l'impédance dudit capteur associé à un système électronique (10) permettant ladite mesure, caractérisé en ce que, ledit capteur est constitué au moins de deux couches de matériaux (1 et 2), conducteurs d'électricité, disposées en contact les unes contre les autres, recouvrant ladite surface (8), et dont les couches externes sont reliées chacune depuis au moins un point quelconque de leurs surfaces (7) à une borne dudit système électronique (10), lequel système électronique comporte au moins un générateur (11) de courant constant parcourant alors lesdites couches (1 et 2), un microprocesseur (12) associé à au moins une mémoire (13) et permettant en particulier la mesure de la différence de potentiel au bord dudit capteur, le calcul de la dérivée de cette différence de potentiel, la comparaison du résultat obtenu à des valeurs de dérivées stockées dans ladite mémoire (13) et associées chacune à un type d'impact déterminé préalablement, et l'émission de signal à travers au moins une interface de sortie (15), quand ladite comparaison correspond à un choix de détection et de reconnaissance voulu.

7. Dispositif suivant la revendication 6, caractérisé en ce que les au moins deux dites couches (1 et 2) de matériaux sont souples et compressibles, déformables et élastiques. et séparées par une autre couche (5) de matériau conducteur souple.

8. Dispositif suivant l'une quelconque des revendications 6 et 7, caractérisé en ce que lesdites couches (1 et 2) de matériaux sont souples et séparées par un isolant souple ajouré (5).

9. Dispositif suivant l'une quelconque des revendications 6 à 7, caractérisé en ce que ledit capteur (6) comporte une enveloppe protectrice souple (3), recouvrant lesdites couches (1 et 2) de matériau conducteur.

10. Dispositif suivant l'une quelconque des revendications 6 à 9, caractérisé en ce que lesdits points (7) à partir desquels sont reliées les couches de matériaux conducteurs au système électronique (10), sont éloignés le plus possible les uns des autres.

11. Dispositif suivant l'une quelconque des revendications 6 à 10, caractérisé en ce que ledit capteur est constitué d'un fourreau de toute forme rempli de plusieurs morceaux distincts de matériaux conducteurs, constituant autant de couches externes (1 et 2) et intermédiaires (5) quand on relie les extrémités au système électronique (10).

Fig.1

Fig.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 417 887  (BENDIX)<br>* Page 1, lignes 1-13; page 12, ligne 33 - page 13, ligne 2; revendications 1,4,13; figures 6-8 *<br>--- | 1 | G 01 R  27/02<br>G 01 R  27/26 |
| Y | JOURNAL OF THE AUDIO ENGINEERING SOCIETY, vol. 33, no. 6, juin 1985, pages 430-435, New York, US; J.A.M. CATRYSSE: "On the design of some feedback circuits for loudspeakers"<br>* Page 434, colonne de gauche, dernier alinéa *<br>--- | 1 | |
| A | DE-U-8 706 280  (SIE SENSORIK)<br>--- | | |
| A | FR-A-2 344 006  (KAVLICO)<br>--- | | |
| A | DE-A-2 529 475  (NICOL)<br>--- | | |
| A | GB-A-2 013 434  (EXXON)<br>--- | | |
| A | ELECTRONIC ENGINEERING, vol. 45, no. 540, février 1973, page 27; D.W. RUSSELL: "Detecting capacitance changes in transducers"<br>----- | | |

**DOMAINES TECHNIQUES RECHERCHES (Int. Cl.4)**

G 01 D
G 01 R
G 01 L
H 04 R

Le présent rapport a été établi pour toutes les revendications

| Lieu de la recherche | Date d'achèvement de la recherche | Examinateur |
|---|---|---|
| LA HAYE | 08-09-1989 | HOORNAERT W. |